# EUROPEAN PATENT SPECIFICATION

(11) **EP 1 394 615 B1**
(45) Date of publication and mention of the grant of the patent: **01.05.2013**
(21) Application number: 03255324.0
(22) Date of filing: 27.08.2003
(51) Int. Cl.: G03F 7/20

(54) **Lithographic apparatus and device manufacturing method**
Lithographischer Projektionsapparat und Verfahren zur Herstellung einer Vorrichtung
Appareil de projection lithographique et méthode de fabrication d'un dispositif

(30) Priority: 30.08.2002 EP 02256037
(43) Date of publication of application: 03.03.2004
(73) Proprietor: ASML Netherlands B.V., 5504 DR Veldhoven (NL)
(72) Inventor: Dierichs, Marcel Mathijs Theodore Marie, 5914 WR Venlo (NL)
(74) Representative: Slenders, Petrus J. W.

(56) References cited:
- EP-A- 1 039 510
- EP-A- 1 235 114
- US-A- 5 081 635

## Description

The present invention relates to a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned projection beam onto a target portion of the substrate,
- a sensor for detecting luminescent radiation radiated by at least a region of the area on a component of one of the radiation system and the projection system, traversed by one of the unpatterned projection beam and the patterned projection beam respectively,
- means for determining the intensity, in said region, of said one of the unpatterned projection beam and the patterned projection beam from the detected luminescent radiation.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g,* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus-commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In order to ensure that the resist receives the correct exposure dose, it is important that the intensity of the radiation beam at substrate level be controlled during exposure. Unfortunately, intensity measurement during exposure is very difficult to perform without either altering the intensity or altering the intensity distribution (uniformity). Therefore in conventional lithographic apparatus, a combination of sensors is typically used to minimize the disturbance - a first sensor normally attached to the substrate table such that it can be positioned in the beam for measurements between exposures, and a second sensor at a suitable position in the optical path, for example mounted on a portion of a reflector, to measure the intensity of a region of the beam during exposure. Using the first sensor between exposures, very accurate measurements may be made of the beam intensity and the beam intensity distribution, and the characteristics of the apparatus may be analyzed by measuring the relative intensities measured by the different sensors under different conditions. This data can then be used to predict the intensity at substrate level using only measurements by the second sensor. The disadvantage of this is that there will always be either a disturbance in the intensity due to the presence of the second sensor.

Alternatively, one of the reflectors in the apparatus may be partially silvered, allowing a portion of the incident radiation to pass through the reflector to a sensor behind the reflector, or may redirect a portion of the beam to a sensor. This arrangement intrinsically reduces the intensity of the projection beam, which in turn reduces the throughput of the apparatus. Apparatus using EUV radiation is especially sensitive to this problem since EUV reflectors are naturally very inefficient. High reflectivity mirrors for EUV radiation are not currently available. Furthermore, in lithographic projection apparatus employing EUV radiation, the projection beam is radiated in an evacuated system to prevent losses in intensity. Therefore the beam intensity sensors must also be located within the evacuated system and must therefore be designed to be vacuum tolerant and to not outgas when placed in the vacuum.

European Patent Application publication EP1235114 discloses a lithographic projection apparatus provided with a sensor for detecting luminescence radiation produced in the projection lens system by the passage of a projection beam. The sensor is arranged to measure an overall, projection-beam cross-section-integrated exposure dose. European Patent Application publication EP1039510 discloses a lithographic apparatus comprising a spatial image sensor at substrate level, for use with EUV exposure light. The sensor includes a fluorescent component converting incident EUV light into radiation detectable by, for example, a photomultiplier.

It is an object of the present invention to provide a means for determining the intensity of the projection beam that can determine the intensity of the beam across its cross-sectional area and is compatible for use with EUV apparatus.

This and other objects are achieved according to the invention in a lithographic apparatus according to claim 1.

The intensity, in said region, of said one of the unpatterned projection beam and the patterned projection beam is determined from the detected luminescent radiation. Luminescence is the spontaneous emission of radiation from a thermally excited substance. Several different types of luminescence are known and identified based upon the mechanism by which the thermally excited state is created, for example photoluminescence (the excited state is produced by the absorption of photons), radioluminescence (arising from excitation by high-energy particles or radiation), sonoluminescence (arising from excitation by sound waves), triboluminescence (arising from the rubbing together of the surface of certain solids) and chemiluminscence (arising from a chemical reaction). Additionally, the luminescence can also be identified by the relationship between excitation and emission, for example fluorescence (emission occurs only during the excitation of a substance) and phosphorescence (emission occurs or continues after excitation of a substance has ceased).

The degree of luminescence (presumably caused by state transitions of the atoms in the surface induced by the incident beam of radiation) produced by a component of the apparatus by the incidence of the projection beam is determined by several factors including the properties of the incident energy beam (for example photon energy and wavelength) and the properties of the component (for example the materials used).

Since the distribution of the luminescent radiation is generally random, the sensor need not be in the beam path. Consequently, the beam of radiation will not be altered by the presence of the sensor. Therefore the sensor may be used to detect the intensity of the beam of radiation across the entire cross-section of the beam and the distribution of the intensity may be determined as well as the overall intensity of the beam.

The element from which the luminescent radiation is detected may be a multilayer stack forming a distributed Bragg reflector or a grazing-incidence collector. In particular, the element part of the projection system and/or part of the radiation system and may be the first reflector on which the unpatterned projection beam is incident. The element may, especially, be part of the illuminator.

The sensor may detect the combined intensity of the luminescent radiation over a broad spectrum. Alternatively, to more accurately determine the intensity of the beam of radiation, the sensor may detect the intensity of luminescent radiation in one or more narrow bands of wavelengths that correspond to the expected wavelengths of radiation to be emitted as a result of state transitions of the atoms in the reflector induced by the beam of radiation.

Since the projection beam is EUV radiation, the patterning means, the projection system, the substrate and at least part of the radiation system are contained in an evacuated chamber to reduce losses in beam intensity due to absorption of the EUV radiation. However, since the luminescent radiation will be at a different wavelength, for example within the visible spectrum, it will not be absorbed to the same extent as the EUV radiation. In a preferred embodiment, therefore, the sensor can be located outside of the evacuated chamber. Consequently the sensor does not need to be vacuum compatible.

The determined intensity of the regions of the unpattemed projection beam or the patterned projection beam from which the luminescent radiation is detected may be used to adjust the exposure time of the target portion of the substrate, the intensity of the beam of radiation produced by the radiation system, or to make adjustments to the intensity distribution of the projection beam.

According to a further aspect of the invention there is provided a device manufacturing method according to claim 9.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus;
Figure 2 depicts an arrangement of the sensor according to an embodiment of the invention; and
Figure 3 depicts a projection system comprised of reflectors.

In the Figures, corresponding reference symbols indicate corresponding parts.

### Embodiment 1

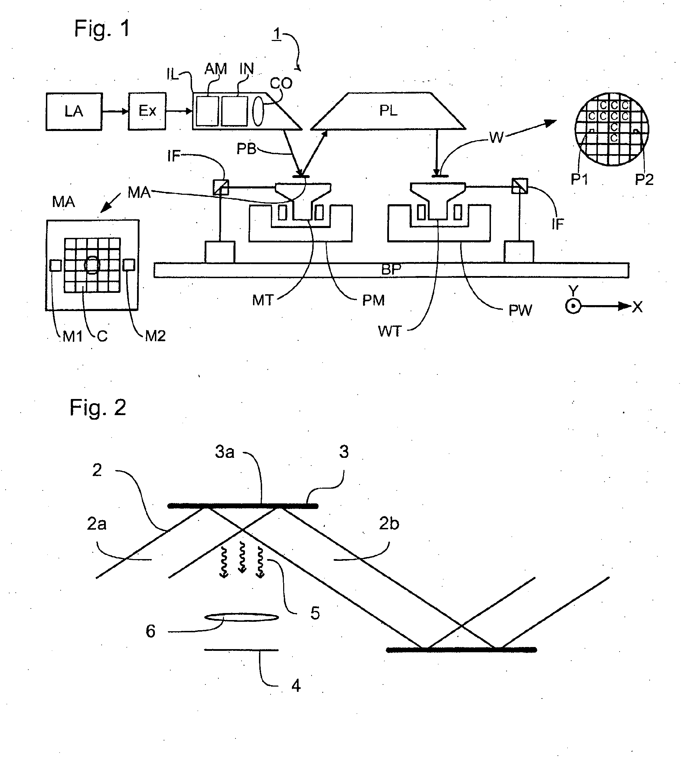

Figure 1 schematically depicts a lithographic projection apparatus. The apparatus comprises:
- a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means PM for accurately positioning the mask with respect to item PL;
- a second object table (substrate table) WT provided with a substrate holder for holding a substrate W (*e.g.* a resist-coated silicon wafer), and connected to second positioning means PW for accurately positioning the substrate with respect to item PL;
- a projection system ("lens") PL (*e.g.* a mirror group) for imaging an irradiated portion of the mask MA onto a target portion C (*e.g.* comprising one or more dies) of the substrate W.
As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v,* so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

Figure 2 depicts an embodiment of the present invention. A beam of radiation 2 traverses a reflector 3. The radiation will cause electrons in atoms of the surface 3a of the reflector 3 to move to higher energy states. As the electrons return to lower energy levels, the atoms radiate luminescent radiations. The wavelengths of the luminescent radiation depend on the quanta of energy released when the electrons drop to a lower energy level. The luminescent radiation emitted by the reflector when the radiation beam is incident on it is therefore comprised of radiation in a plurality of discrete bands of wavelengths. The intensity of the luminescent radiation in each waveband and the position of the wavebands will be dependent on the material from which the reflector is made and the intensity of the incident beam.

The luminescent radiation is radiated in all the directions. Therefore a sensor 4 may be placed to detect the luminescent radiation from the surface 3a without being within the incident path 2a or the reflected path 2b of the beam of radiation 2. The sensor 4 may be a CCD camera or a single diode.

The sensor 4 may detect the luminescent radiation 5 from the entire area 3a of the reflector 3 on which the beam of radiation 2 is incident. Alternatively, with the use of appropriate optics, such as a lens 6, the image of the area 3a of the reflector 3 on which the beam of radiation 2 is incident may be projected onto the sensor 4. The sensor 4 can then be used to monitor the intensity of the beam of radiation over its cross-section. This is useful as, in a projection beam for example, it is desirable to ensure that the beam intensity is uniform across its cross-section.

Whether the sensor detects the luminescent radiation from the entire area 3a of the reflector on which the beam 2 is incident or from discrete regions within it, the sensor 4 may detect the total luminescent radiation (i.e. of substantially all wavelengths) from the reflector 3, from which a control device can estimate the intensity of the beam of radiation or the region of the beam of radiation. Alternatively, the sensor may detect the intensity of the luminescent radiation at a plurality of specific wavelengths associated with electron state changes in the material of the reflector. The control device can then determine the intensity of the beam of radiation or the intensity of the region of the beam of radiation more accurately from the probabilities of state changes in the atoms of the reflector and the intensities of the luminescent radiation in each of the associated wavelengths.

From monitoring the intensity of specific wavelengths, it is also possible to characterize contamination on the reflector. For instance, it may be possible to determine the composition and/or the thickness of a contamination layer on the surface of the reflector since the characteristic electron state charges of the contaminant will be different to those of the reflector.

The sensor may be used in conjunction with any surface on which a beam of radiation is incident. In particular, it may be used with the unpatterned projection beam of radiation or the patterned projection beam. In the case of the former, the sensor is preferably used in conjunction with a reflector that is close to the radiation source. At each reflection, the intensity of the beam of radiation decreases and hence the amount of luminescent radiation irradiated from each surface decreases. The sensor may therefore be used in conjunction with a reflector that is part of the radiation system or immediately down-beam of the radiation system.

In particular, the sensor may be used in conjunction with field and/or pupil faceted mirrors in the illumination system. These are used to improve the uniformity of the intensity over the cross section of the projection beams. The facet mirrors may need to be adjusted to attain the required field intensity distribution. The sensor can be used to determine the intensity distribution of the projection beam either at the facet mirrors or at a subsequent element. The required adjustments to the facet mirrors can therefore be determined. Further information on field and pupil facet mirrors is explained in European Patent Application No. 02251933.4.

It will be appreciated that the sensor may also be used in conjunction with a reflector that is as far down-beam as practical so as to be able to monitor the losses of as many reflectors as possible. As an alternative, the sensor could be used in conjunction with a reflector immediately down-beam of the patterning means. This could be used, for example when the patterning means is a programmable patterning means, to confirm that the intensity distribution across the patterning means is as expected and/or provide feedback to the programmable patterning means to provide necessary corrections.

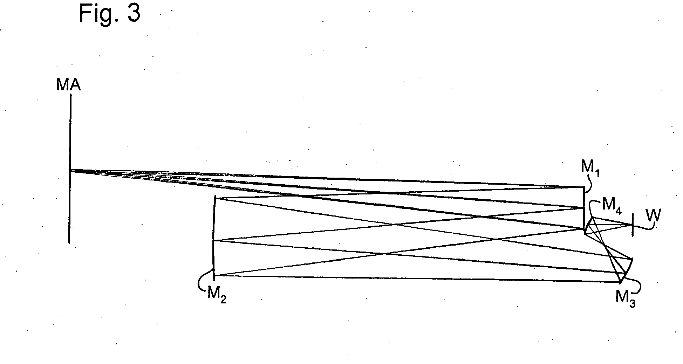

The sensor may, especially, be used in conjunction with a reflector in the projection system. Since no suitable material for manufacturing refractive lenses usable with EUV radiation is known, projection systems for lithographic apparatus making use of EUV radiation for the projection beam must be based on reflective optics. An example of such a projection system is shown in Figure 3. The reflectors M₁, M₂, M₃, M₄ are used to project an image of the patterning means MA onto the substrate W. Further information on projection systems using reflective optics may be found in EP 1,209,503A.

In the case of lithographic projection apparatus which uses EUV radiation, the reflectors will be distributed Bragg reflectors, for example comprised of a plurality of alternating layers of molybdenum and silicon. These distributed Bragg reflectors may be capped, to protect the lower layers. The majority of the luminescent radiation may be radiated from this capping layer and the material used for the capping layer may therefore be selected to maximize the luminescent radiation. Alternatively, any of the reflectors that may be used for the present invention or specific areas of them may be coated with an additional fluorescent layer to enhance the luminescent irradiation.

The sensor 4 may simply be adjacent to the reflector 3. However, this need not be the case. In apparatus in which the beam of radiation 2 is EUV radiation, then the beam path may be within an evacuated chamber to reduce the intensity loss. However, the luminescent radiation 5 will have a different wavelength and therefore it will be less susceptible to intensity loss. The sensor 4 may, therefore, be located outside of the evacuated chamber, with the luminescent radiation 5 passing through a panel that is transmissive to the luminescent radiation.

Determining the intensity of regions of the projection beams or the patterned beam (or of the entirety of the beams) may be used to ensure that the resist on the substrate receives the correct exposure. This may be done, for example, by adjusting the exposure time of the resist or the intensity of the beam of radiation produced by the radiation system in response to the measured intensity values.

Whilst specific embodiments of the invention have been described above, it will be appreciated that the invention may be practiced otherwise than as described. The description is not intended to limit the invention which is defined by the claims.

## Claims

1. A lithographic projection apparatus (1) comprising:
- a radiation system (LA, Ex, IL) for providing a projection beam (PB, 2) of radiation;
- a support structure (MT) for supporting patterning means (MA), the patterning means serving to pattern the projection beam according to a desired pattern;
- a substrate table (WT) for holding a substrate (W);
- a projection system (PL) for projecting the patterned projection beam onto a target portion (C) of the substrate (W),
- a sensor (4) arranged to detect luminescent radiation (5) radiated by a plurality of regions of the area (3a) on a component (3) of one of the radiation system (LA Ex, IL) and the projection system (PL), on which one of the unpatterned projection beam and the patterned projection beam is incident,
- means for determining the intensity, in said plurality of regions, of said one of the unpatterned projection beam and the patterned projection beam from the detected luminescent radiation (5),
**characterized in that**:
- said means for determining the intensity of the beam is arranged to determine the intensity of said one of the projection beam and patterned beam in each region of the said plurality of regions.

2. A lithographic projection apparatus according to claim 1, wherein the component is a reflector (3) and said sensor (4, 6) is not in the incident path (2a) or the reflected path (2b) of said one of the unpatterned projection beam and the patterned projection beam.

3. A lithographic projection apparatus according to any one of the preceding claims, wherein the component is a multilayer stack forming a distributed Bragg reflector.

4. A lithographic projection apparatus according to any one of the preceding claims, wherein said component is a reflector (3) within one of the projection system and the radiation system.

5. A lithographic projection apparatus according to any one of the preceding claims, wherein the sensor (4) detects the total intensity of luminescent radiation radiated by said regions.

6. A lithographic projection apparatus according to any one of the preceding claims, wherein the sensor (4) detects the intensity of luminescent radiation radiated by said regions at one or more specific wavelengths.

7. A lithographic projection apparatus according to claim 2, wherein:
- the patterning means MA, the projection system (PL), the substrate (W) and at least part of the radiation system (Ex, IL) are contained in an evacuated chamber;
- said region of the reflector (3), from which the sensor (4) detects luminescent radiation (5), is within the evacuated chamber; and
- the sensor (4) is located outside of the evacuated chamber.

8. A lithographic projection apparatus according to any one of the preceding claims, further comprising means for adjusting one of the exposure time of the target portion (C) of the substrate (W), the intensity of the beam of radiation produced by the radiation system and the intensity distribution of the projection beam in response to the detected luminescent radiation (5).

9. A device manufacturing method comprising the steps of:
- providing a substrate (W) that is at least partially covered by a layer of radiation-sensitive material;
- providing a projection beam (PB) of radiation using a radiation system (LA, Ex, IL);
- using patterning means (MA) to endow the projection beam (PB) with a pattern in its cross-section;
- projecting the patterned projection beam of radiation onto a target portion (C) of the layer of radiation-sensitive material,
- using a sensor (4) to detect luminescent radiation (5) radiated by a plurality of regions of the area (3a) on a component (3) of one of the radiation system (LA, Ex, IL) and the projection system (PL) on which one of the unpatterned projection beam and the patterned projection beam is incident,
- determining the intensity, in said plurality of regions, of said one of the unpatterned projection beam and the patterned projection beam from the detected luminescent radiation,
**characterized by**:
- determining the intensity of the beam of said one of the projection beam and patterned beam in each region of the said plurality of regions.

## Patentansprüche

1. Ein lithographisches Projektionsgerät (1), das Folgendes beinhaltet:
- ein Strahlungssystem (LA, Ex, IL) zum Bereitstellen eines Projektionsstrahls (PB, 2) aus Strahlung;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Projektionsstrahls auf einen Zielabschnitt (C) des Substrats (W);
- einen Sensor (4), der eingerichtet ist, um lumineszierende Strahlung (5) zu erfassen, die von einer Vielzahl von Bereichen der Fläche (3a) auf einer Komponente (3) eines von dem Strahlungssystem (LA, Ex, IL) und dem Projektionssystems (PL), auf die einer von dem ungemusterten Projektionsstrahl und dem gemusterten Projektionsstrahl einfällt, abgestrahlt wird;
- ein Mittel zum Bestimmen der Intensität des einen von dem ungemusterten Projektionsstrahl und dem gemusterten Projektionsstrahl in der Vielzahl von Bereichen aus der erfassten lumineszierenden Strahlung (5);
**dadurch gekennzeichnet, dass**:
- das Mittel zum Bestimmen der Intensität des Strahls eingerichtet ist, um die Intensität des einen von dem Projektionsstrahl und dem gemusterten Strahl in jedem Bereich der Vielzahl von Bereichen zu bestimmen.

2. Lithographisches Projektionsgerät gemäß Anspruch 1, wobei die Komponente ein Reflektor (3) ist und der Sensor (4, 6) nicht in dem Einfallsweg (2a) oder dem Reflexionsweg (2b) des einen von dem ungemusterten Projektionsstrahl und dem gemusterten Projektionsstrahl liegt.

3. Lithographisches Projektionsgerät gemäß einem der vorhergehenden Ansprüche, wobei die Komponente ein mehrschichtiger Stapel ist, der einen verteilten Bragg-Reflektor bildet.

4. Lithographisches Projektionsgerät gemäß einem der vorhergehenden Ansprüche, wobei die Komponente ein Reflektor (3) innerhalb eines von dem Projektionssystem und dem Strahlungssystem ist.

5. Lithographisches Projektionsgerät gemäß einem der vorhergehenden Ansprüche, wobei der Sensor (4) die Gesamtintensität der von den Bereichen abgestrahlten lumineszierenden Strahlung erfasst.

6. Lithographisches Projektionsgerät gemäß einem der vorhergehenden Ansprüche, wobei der Sensor (4) die Intensität der von den Bereichen abgestrahlten lumineszierenden Strahlung auf einer oder mehreren spezifischen Wellenlängen erfasst.

7. Lithographisches Projektionsgerät gemäß Anspruch 2, wobei
- das Musteraufbringungsmittel MA, das Projektionssystem (PL), das Substrat (W) und mindestens ein Teil des Strahlungssystems (Ex, IL) in einer evakuierten Kammer enthalten sind;
- der Bereich des Reflektors (3), aus dem der Sensor (4) lumineszierende Strahlung (5) erfasst, innerhalb der evakuierten Kammer liegt; und
- sich der Sensor (4) außerhalb der evakuierten Kammer befindet.

8. Lithographisches Projektionsgerät gemäß einem der vorhergehenden Ansprüche, das ferner ein Mittel zum Einstellen eines von der Belichtungszeit des Zielabschnitts (C) des Substrats (W), der Intensität des von dem Strahlungssystem produzierten Strahls aus Strahlung und der Intensitätsverteilung des Projektionsstrahls als Reaktion auf die erfasste lumineszierende Strahlung (5) beinhaltet.

9. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Bereitstellen eines Projektionsstrahls (PB) aus Strahlung unter Verwendung eines Strahlungssystems (LA, Ex, IL);
- Verwenden eines Musteraufbringungsmittels (MA), um den Projektionsstrahl (PB) in seinem Querschnitt mit einem Muster zu versehen;
- Projizieren des gemusterten Projektionsstrahls aus Strahlung auf einen Zielabschnitt (C) der Schicht aus strahlungsempfindlichem Material;
- Verwenden eines Sensors (4), um lumineszierende Strahlung (5) zu erfassen, die von einer Vielzahl von Bereichen der Fläche (3a) auf einer Komponente (3) eines von dem Strahlungssystem (LA, Ex, IL) und dem Projektionssystems (PL), auf die einer von dem ungemusterten Projektionsstrahl und dem gemusterten Projektionsstrahl einfällt, abgestrahlt wird;
- Bestimmen der Intensität des einen von dem ungemusterten Projektionsstrahl und dem gemusterten Projektionsstrahl in der Vielzahl von Bereichen aus der erfassten lumineszierenden Strahlung;
**gekennzeichnet durch**:
- Bestimmen der Intensität des Strahls des einen von dem Projektionsstrahl und dem gemusterten Strahl in jedem Bereich der Vielzahl von Bereichen.

## Revendications

1. Un appareil de projection lithographique (1) comprenant :
- un système de rayonnement (LA, Ex, IL) destiné à fournir un faisceau de projection (PB, 2) de rayonnement ;
- une structure formant support (MT) destinée à supporter un moyen pour conformer selon un motif (MA), le moyen pour conformer selon un motif servant à conformer le faisceau de projection selon un motif souhaité ;
- une table porte-substrat (WT) destinée à porter un substrat (W) ;
- un système de projection (PL) destiné à projeter le faisceau de projection conformé selon un motif sur une portion cible (C) du substrat (W),
- un capteur (4) arrangé pour détecter un rayonnement luminescent (5) émis par une pluralité de régions de la zone (3a) sur un composant (3) d'un système d'entre le système de rayonnement (LA, Ex, IL) et le système de projection (PL), sur lequel est incident un faisceau d'entre le faisceau de projection non conformé selon un motif et le faisceau de projection conformé selon un motif,
- un moyen destiné à déterminer l'intensité, dans ladite pluralité de régions, de ce dit faisceau d'entre le faisceau de projection non conformé selon un motif et le faisceau de projection conformé selon un motif à partir du rayonnement luminescent (5) détecté,
**caractérisé en ce que** :
- ledit moyen destiné à déterminer l'intensité du faisceau est arrangé pour déterminer l'intensité de ce dit faisceau d'entre le faisceau de projection et le faisceau conformé selon un motif dans chaque région de ladite pluralité de régions.

2. Un appareil de projection lithographique selon la revendication 1, dans lequel le composant est un réflecteur (3) et ledit capteur (4, 6) ne se trouve ni sur le trajet incident (2a) ni sur le trajet réfléchi (2b) de ce dit faisceau d'entre le faisceau de projection non conformé selon un motif et le faisceau de projection conformé selon un motif.

3. Un appareil de projection lithographique selon l'une quelconque des revendications précédentes, dans lequel le composant est un empilement multicouche formant un réflecteur de Bragg distribué.

4. Un appareil de projection lithographique selon l'une quelconque des revendications précédentes, dans lequel ledit composant est un réflecteur (3) au sein d'un système d'entre le système de projection et le système de rayonnement.

5. Un appareil de projection lithographique selon l'une quelconque des revendications précédentes, dans lequel le capteur (4) détecte l'intensité totale du rayonnement luminescent émis par lesdites régions.

6. Un appareil de projection lithographique selon l'une quelconque des revendications précédentes, dans lequel le capteur (4) détecte l'intensité du rayonnement luminescent émis par lesdites régions à une ou plusieurs longueurs d'onde spécifiques.

7. Un appareil de projection lithographique selon la revendication 2, dans lequel :
- le moyen pour conformer selon un motif MA, le système de projection (PL), le substrat (W) et au moins une partie du système de rayonnement (Ex, IL) sont contenus dans une chambre mise sous vide ;
- ladite région du réflecteur (3), à partir de laquelle le capteur (4) détecte le rayonnement luminescent (5), se trouve au sein de la chambre mise sous vide ; et
- le capteur (4) est situé à l'extérieur de la chambre mise sous vide.

8. Un appareil de projection lithographique selon l'une quelconque des revendications précédentes, comprenant en outre un moyen pour ajuster soit le temps d'exposition de la portion cible (C) du substrat (W), soit l'intensité du faisceau de rayonnement produit par le système de rayonnement, soit la distribution de l'intensité du faisceau de projection en réponse au rayonnement luminescent (5) détecté.

9. Un procédé de fabrication de dispositif comprenant les étapes consistant à :
- fournir un substrat (W) qui est au moins partiellement recouvert d'une couche de matériau sensible au rayonnement ;
- fournir un faisceau de projection (PB) de rayonnement à l'aide d'un système de rayonnement (LA, Ex, IL) ;
- utiliser un moyen pour conformer selon un motif (MA) afin de doter le faisceau de projection (PB) d'un motif dans sa coupe transversale ;
- projeter le faisceau de projection de rayonnement conformé selon un motif sur une portion cible (C) de la couche de matériau sensible au rayonnement,
- utiliser un capteur (4) afin de détecter un rayonnement luminescent (5) émis par une pluralité de régions de la zone (3a) sur un composant (3) d'un système d'entre le système de rayonnement (LA, Ex, IL) et le système de projection (PL) sur lequel est incident un faisceau d'entre le faisceau de projection non conformé selon un motif et le faisceau de projection conformé selon un motif,
- déterminer l'intensité, dans ladite pluralité de régions, de ce dit faisceau d'entre le faisceau de projection non conformé selon un motif et le faisceau de projection conformé selon un motif à partir du rayonnement luminescent détecté, **caractérisé par** le fait de :
- déterminer l'intensité du faisceau de ce dit faisceau d'entre le faisceau de projection et le faisceau conformé selon un motif dans chaque région de ladite pluralité de régions.
